# EUROPEAN PATENT SPECIFICATION

(11) **EP 2 770 025 B1**
(45) Date of publication and mention of the grant of the patent: **18.01.2017**
(21) Application number: 11874240.2
(22) Date of filing: 18.10.2011
(51) Int. Cl.: C08L 63/00, C08L 47/00, C08K 13/02, C08K 3/36, C08K 5/3492, B32B 27/04, B32B 15/08, H05K 1/03, C08C 19/06, C08G 59/34, C08K 5/00, C08G 73/02, C08K 5/357, C08K 5/5313, C08L 15/00, C08L 79/02, H05K 3/02, B32B 5/02, B32B 15/14, B32B 15/20

(54) **HALOGEN-FREE LOW-DIELECTRIC RESIN COMPOSITION, AND PREPREG AND COPPER FOIL LAMINATE MADE BY USING SAME**
HALOGENFREIE HARZZUSAMMENSETZUNG MIT EINEM NIEDRIGDIELEKTRISCHEN HARZ SOWIE PREPREG UND KUPFERFOLIENLAMINAT DARAUS
COMPOSITION DE RÉSINE À FAIBLE CONSTANTE DIÉLECTRIQUE EXEMPTE D'HALOGÈNE ET PRÉIMPRÉGNÉ OBTENU À PARTIR D'UN STRATIFIÉ CUIVRÉ ET PARTIES SOLIDES ORGANIQUES DE LA COMPOSITION DE RÉSINE À FAIBLE CONSTANTE DIÉLECTRIQUE EXEMPTE D'HALOGÈNE

(43) Date of publication of application: 27.08.2014
(73) Proprietor: Shengyi Technology Co., Ltd, Dongguan, Guangdong 523808 (CN)
(72) Inventor: RONG, Qianping, Dongguan Guangdong 523808 (CN); HE, Yueshan, Dongguan Guangdong 523808 (CN); SU, Shiguo, Dongguan Guangdong 523808 (CN)
(74) Representative: Ricker, Mathias
(86) International application number: PCT/CN2011/080943
(87) International publication number: WO 2013/056426

(56) References cited:
- EP-A1- 1 985 654
- EP-A1- 2 290 009
- EP-A2- 0 138 609
- CN-A- 101 831 144
- CN-A- 102 010 568
- CN-A- 102 504 532
- JP-A- H0 517 544
- JP-A- 2000 007 901
- JP-A- 2005 002 226
- JP-A- 2006 316 104
- JP-A- 2007 169 454
- JP-A- 2008 195 846
- JP-A- 2010 256 728
- US-A1- 2011 053 447
- US-A1- 2011 059 324

## Description

### Technical field

The present invention relates to a resin composition, especially a halogen-free low-dielectric resin composition, and prepreg used in printed circuit boards and copper foil laminate made by using same

### Background art

As for the high-speed and high-frequency signal transmission in printed circuit boards, the smaller the signal attenuation is, the more advantageous it is to obtain a more complete signal. Recently, the demand for low dielectric copper clad plate is further increased along with the rapid development of information industry, and the sheet materials are required to have lower dielectric constant and less dielectric loss. The common FR-4 has a dielectric constant (Dk) of 4.3-4.8 at the condition of 1 GHz and a dielectric loss (Df) of 0.02-0.025, and has a dielectric constant (Dk) of 4.5-5.0 at the condition of 1 MHz and a dielectric loss (Df) of 0.015-0.02. Thus the common FR-4 cannot meet the requirements on the transmission rate of high frequency signal and the integrity of signal transmission.

There are various methods for preparing dielectric copper clad plates, such as cyanate-type, polyphenylene oxide-type, tetrafluoroethylene-type, bismaleimide-type copper clad plates, but they have the problems such as high price, complex process. There are fewer patents for preparing copper clad plate by using the low polarity and flexibility of polybutadiene. It is reported in Chinese Patent No.200710162020.9 that the resin plate prepared form 1,2-polybutadiene under the step-by-step free radical polymerization of low-temperature and high-temperature initiators has a Dk of 2.5 and a Df of 0.0015; the laminate has a Dk of 3.2 and a Df of 0.0024. However, it will be observed that polybutadiene exudes from the laminate. Moreover, it has a lower glass transition temperature and heat resistance, a worse adhesiveness to copper foil and a general solvent resistance.

### Contents of the invention

The object of the present invention lies in providing a halogen-free low-dielectric resin composition, wherein the epoxidized polybutadiene not only improves the shortcomings of polybutadiene, but also maintains the advantages in dielectric property and flexibility, so as to make the composition have excellent dielectric performance.

Another object of the present invention lies in providing a prepreg and copper foil laminate made by using the halogen-free low-dielectric resin composition, which have excellent dielectric performance, better heat resistance and high glass transition temperature and can meet the requirements on the high frequency of electric signal transmission and high speed information processing in printed circuit copper clad plate industry.

In order to achieve said objects, the present invention provides a halogen-free low-dielectric resin composition, comprising based on the weight of the organic solid,
from 5 to 90 parts by weight of epoxidized polybutadiene resin;
from 10 to 90 parts by weight of benzoxazine resin;
from 10 to 90 parts by weight of epoxy resin;
from 1 to 50 parts by weight of a curing agent;
from 10 to 50 parts by weight of an organic fire retardant;
from 0.01 to 1 parts by weight of a curing accelerator;
from 0.1 to 10 parts by weight of an initiator; and
from 10 to 100 parts by weight of a packing,
wherein the initiator is a peroxide having the following structural formula 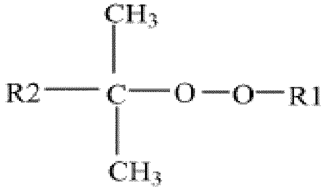 wherein R1 and R2 are H, alicyclic hydrocarbon with 3 to 20 carbon atoms and derivatives thereof, aliphatic hydrocarbon with 1 to 20 carbon atoms and derivatives thereof, or unsaturated aliphatic hydrocarbon with 2 to 20 carbon atoms and derivatives thereof.

A halogen-free flame retardant resin composition suitable for making a prepreg, a laminate, and a laminate for printed circuit is known from EP 2 290 009 A1. The resin composition comprises: (A) 40-80 parts by weight of the mixture of a phenoxyphosphazene compound (A1) and a dihydrobenzoxazine ring-containing compound (A2), wherein the weight ratio between A1 and A2 is between 1:10 and 1:2; (B) 15- 5 parts by weight of a polyepoxy compound; (C) 5-25 parts by weight of a phenolic resin type hardener; and (D) 0.1-1 parts by weight of an imidazole type compound as a curing accelerator.

US 2011/059324 A1 discloses another halogen-free flame retardant resin composition comprising a dihydrobenzoxazine ring-containing compound and a phenoxyphosphazene compound in a weight ratio of between 1:10 and 1:2, and further discloses a prepreg, a laminate, and a laminate for printed circuit that are made thereof.

Further resin compositions, prepregs, laminates and/or printed circuit boards are known from US 2011/053447 A1, EP 1 985 654 A1, and EP 0 138 609 A2. More specifically, US 2011/053447 A1 discloses a halogen-free resin composition, and a prepreg and a laminate made therefrom, wherein the composition comprises: (A) 10-50 parts by weight of a copolymer of styrene-maleic anhydride, (B) 10-50 parts by weight of at least one compound having a dihydrobenzoxazine ring, (C) 10-50 parts by weight of at least one polyepoxide, and (D) 5-30 parts by weight of at least one phosphorus-containing flame retardant.

EP 1 985 654 A1 discloses a thermosetting resin composition which can be used for the production of printed circuit boards, comprising (A) a polyphenylene ether, and a prepolymer formed from (B) a chemically unmodified butadiene polymer containing 40% or more of a 1,2-butadiene unit having a 1,2-vinyl group in a side chain of a molecule, and (C) a crosslinking agent, in a compatibilized and uncured state.

EP 0 138 609 A2 discloses a resin composition for use as a bonding agent in the preparation of laminated boards, which consists essentially of (1) an epoxidized butadiene polymer containing at least 0.3 mol of epoxy group per 100 g of the polymer and (2) a novalak type phenol resin and/or polyvinyl phenol.

Moreover, yet further resin compositions suitable for preparing printed wiring/circuit boards or copper clad laminated boards are known from the JP patent applications described below. JP 2006-316104 A discloses a thermosetting resin, containing (a) 35-75 parts by weight of a resin having a dihydrobenzoxazine ring in the molecule, (b) 10-25 parts by weight of a polycondensate of a phenol, a triazine ring-bearing compound and an aldehyde, (c) 10-45 parts by weight of an epoxy resin, (d) 5-35 parts by weight of a condensed phosphoric ester, (e) 0.5-10 parts by weight of an epoxidized polybutadiene and (f) 0.5-10 parts by weight of an organophosphorus compound, based on a total of 100 parts by weight of the organic solids of components(a), (b) and (c), and further containing (g) 30-100 parts by weight of an inorganic filler based on a total of 100 parts by weight of the solids of components(a), (b), (c), (d), (e) and (f).

JP 2000-007901 A discloses a resin composition suitable for preparing a copper clad laminated board, containing a compound having a dihydrobenzoxazine ring, an epoxidized polybutadiene having a number average molecular weight of 500-10,000 containing 3-12 wt.% of oxirane oxygen in an amount such that it constitutes 1-25 wt.% of the solids content of the resin, and a curing accelerator.

JP 2010-256728 A discloses a photocurable thermosetting resin composition for use in the manufacturing of a printed wiring board, wherein the resin composition contains (A) a carboxyl group-containing resin (except a carboxyl group-containing resin formed by using an epoxy resin as a starting raw material), (B) a photopolymerization initiator, (C) an epoxidized polybutadiene, and, preferably, (D) a thermosetting component, and further preferably, (G) a colorant.

JP 2008-195846 A discloses a resin composition for a printed circuit board, comprising (a) an epoxidized polybutadiene where the unsaturated double bond portions of polybutadiene are epoxidized, (b) an epoxy resin having, in one molecule, two or more epoxy groups, (c) an amine-based curing agent, and (d) an ester group-bearing curing agent.

JP H05-17544 A discloses a composition suitable as a resin for substrates of electric equipment printed circuit boards, comprising (A) a fluorine-containing maleimide compound, (B) an epoxidized polybutadiene, (C) a halogen atom-containing bismaleimide compound, and (D) an anionic polymerization initiator and/or an organic peroxide.

Said polybutadiene epoxy resin comprises at least one of the compounds having the following structural formula (I) 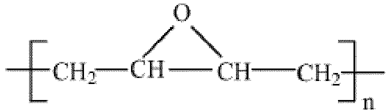 wherein the formula (I) represents cis-1,4-epoxidized polybutadiene, trans-1,4-epoxidized polybutadiene, cis-1,4-epoxidized hydroxyl terminated polybutadiene, trans-1,4-epoxidized hydroxyl terminated polybutadiene, cis-1,4-epoxidized carboxyl terminated polybutadiene, trans-1,4-epoxidized carboxyl terminated polybutadiene, having a molecular weight of from 100 to 10000; and the formula (II) 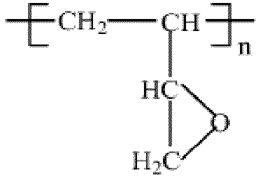 wherein the formula (2) represents 1,2-epoxidized polybutadiene, 1,2-epoxidized hydroxyl terminated polybutadiene, or 1,2-epoxidized carboxyl terminated polybutadiene, having a molecular weight of from 100 to 10000.

Said benzoxazine resin comprises one or more selected from the group consisting of allyl benzoxazine, bisphenol A-type benzoxazine, bisphenol F-type benzoxazine, 4,4'-diaminodiphenylmethane-type benzoxazine, biscyclopentadiene-type benzoxazine.

The epoxy resin comprises at least one of the following compounds
(1) bifunctional epoxy resin, including bisphenol A-type epoxy resin, bisphenol F-type epoxy resin, biphenyl-type epoxy resin, ;naphthalene ring-type epoxy resin, biscyclopentadiene-type epoxy resin and cyanate-type epoxy resin;
(2) novolac epoxy resin, including phenol novolac epoxy resin, bisphenol A-type novolac epoxy resin, and o-methyl novolac epoxy resin;
(3) phosphorous-containing epoxy resin, including 9,10-dihydro-9-oxa-10-phosphaphenanthrene-10-oxide-modified epoxy resin, 10-(2,5-dihydroxylnaphthyl)-9,10-dihydro-9-oxa-10-phosphaphenanthrene-10-oxide-modified epoxy resin, 10-(2,9-dihydroxylnaphthyl)-9,10-dihydro-9-oxa-10-phosphaphenanthrene-10-oxide-modified epoxy resin.

The curing agent is one or more selected from the group consisting of phenol curing agents, amine curing agents, acid or anhydride curing agent and cyanates. The organic fire retardant is selected from the group consisting of melamine, melamine cyanurate, phosphate and compounds thereof, 9,10-dihydro-9-oxa-10-phosphaphenanthrene-10-oxide and compounds thereof, phenoxyl phosphonitrile, or mixtures thereof.

The curing accelerator is one or more selected from the group consisting of 2-methylimidazole, 1-methylimidazole, 2-ethyl-4-methylimidazole, 2-phenylimidazole, 2-hendecylimidazole, and 2-phenyl-4- methylimidazole.

The packing is one or more inorganic packings selected from the group consisting of aluminium hydroxide, magnesium hydroxide, zeolite, wollastonite, silicon dioxide, magnesia, calcium silicate, calcium carbonate, clay, talc and mica.

The initiator is a peroxide having the following structural formula 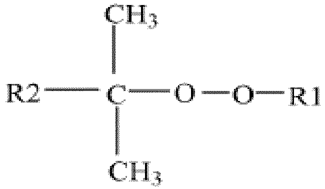 wherein R1 and R2 are H, alicyclic hydrocarbon with 3 to 20 carbon atoms and derivatives thereof, aliphatic hydrocarbon with 1 to 20 carbon atoms and derivatives thereof, or unsaturated aliphatic hydrocarbon with 2 to 20 carbon atoms and derivatives thereof.

The halogen-free low-dielectric resin composition has a halogen content of less than 0.09 wt.%.

Meanwhile, the present invention provides a prepreg fabricated by using the halogen-free low-dielectric resin composition, comprising a base material and a halogen-free low-dielectric resin composition attached thereon after impregnation and drying. The base material is a nonwoven fabric or other fabrics.

Further, the present invention provides a copper foil laminate made by using the halogen-free low-dielectric resin composition, comprising several laminated prepregs, copper foils covered on one or both sides of the laminated prepregs, wherein each of the prepregs comprises a base material and a halogen-free low-dielectric resin composition attached thereon after impregnation and drying.

The present invention has the following beneficial effects. The halogen-free low-dielectric resin composition of the present application uses the epoxidized polybutadiene, which not only improves the shortcomings of polybutadiene, but also maintains the advantages in dielectric property and flexibility, and increases the adhesiveness to copper foils. High heat resistant benzoxazine is added to the formulation so as to cover the shortages of polybutadiene epoxy resin in heat resistance and flame retardance. The residual double bonds may be copolymerized with other resins containing double bonds under the action of the initiator, to increase the crosslinking density and solves the problem of the phase separation which readily occurs in polybutadiene resin. The prepreg and copper foil laminate for printed circuit made by using such resin composition have excellent dielectric performance, better heat resistance and high glass transition temperature and can meet the requirements on the high frequency of electric signal transmission and high speed information processing in printed circuit copper clad plate industry.

### Embodiments

The halogen-free low-dielectric resin composition of the present invention comprises, based on the weight of the organic solid,
from 5 to 90 parts by weight of epoxidized polybutadiene resin;
from 10 to 90 parts by weight of benzoxazine resin;
from 10 to 90 parts by weight of epoxy resin;
from 1 to 50 parts by weight of a curing agent;
from 10 to 50 parts by weight of an organic fire retardant;
from 0.01 to 1 parts by weight of a curing accelerator;
from 0.1 to 10 parts by weight of an initiator; and
from 10 to 100 parts by weight of a packing.

Said polybutadiene epoxy resin comprises at least one of the compounds having the following structural formula (I) 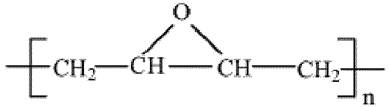 wherein the formula (I) represents cis-1,4-epoxidized polybutadiene, trans-1,4-epoxidized polybutadiene, cis-1,4-epoxidized hydroxyl terminated polybutadiene, trans-1,4-epoxidized hydroxyl terminated polybutadiene, cis-1,4-epoxidized carboxyl terminated polybutadiene, trans-1,4-epoxidized carboxyl terminated polybutadiene, having a molecular weight of from 100 to 10000; and the formula (II) 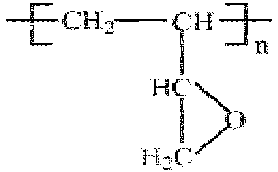 wherein the formula (2) represents 1,2-epoxidized polybutadiene, 1,2-epoxidized hydroxyl terminated polybutadiene, or 1,2-epoxidized carboxyl terminated polybutadiene, having a molecular weight of from 100 to 10000.

Said polybutadiene epoxy may be used alone, or the mixtures of these compounds may be used in an amount of from 5 to 90 parts by weight, preferably from 10 to 50 parts by weight. The liquid epoxidized polybutadiene resin has a molecular weight of from 100 to 10000, preferably less than 5000, and an epoxy equivalent of from 200 to 600 g/mol.

Said benzoxazine resin in the present invention, *i.e.* the compound having benzoxazine ring, is advantageous to increasing the flame retardance, moisture resistance, heat resistance, mechanical performance and electricity performance of the cured resin and the base plate made therefrom. The selected benzoxazine a prepolymer formed from one or more selected from the group consisting of allyl benzoxazine, bisphenol A-type benzoxazine, bisphenol F-type benzoxazine, MDA (4,4'-diaminodiphenylmethane)-type benzoxazine, biscyclopentadiene-type benzoxazine. Benzoxazine having the unsaturated bond structure has a lower dielectric constant, and the double bond thereof and the residual double bond on epoxidized polybutadiene may be free-radical polymerized under the action of the initiator, to avoid the problem that the epoxidized polybutadiene produce the phase separation structure in the product. Thus the present invention preferably uses allyl benzoxazine, and the amount thereof is better from 10 to 90 parts by weight, preferably from 20 to 50 parts by weight.

The epoxy resin of the present invention is preferably the diglycidyl ether epoxy resin and provides the basic mechanical and thermal performance as required by the base plate. The epoxy resin comprises at least one of the following compounds
(1) bifunctional epoxy resin, including bisphenol A-type epoxy resin, bisphenol F-type epoxy resin, biphenyl-type epoxy resin; naphthalene ring-type epoxy resin, biscyclopentadiene-type epoxy resin and cyanate-type epoxy resin; (2) novolac epoxy resin, including phenol novolac epoxy resin, bisphenol A-type novolac epoxy resin, and o-methyl novolac epoxy resin; (3) phosphorous-containing epoxy resin, including 9,10-dihydro-9-oxa-10-phosphaphenanthrene-10-oxide-modified epoxy resin, 10-(2,5-dihydroxylnaphthyl)-9,10-dihydro-9-oxa-10- phosphaphenanthrene-10-oxide-modified epoxy resin, 10-(2,9-dihydroxylnaphthyl)-9,10-dihydro-9-oxa-10-phosphaphenanthrene-10-oxide-modified epoxy resin. Said epoxy resins may be used alone or in combinations according to the use thereof. If biphenyl-type epoxy resin, naphthalene ring-type epoxy resin or o-methyl novolac epoxy resin is used, the condensate will have a higher glass transition temperature and a better heat resistance; if the phosphorous-containing epoxy resin is used, the phosphorus as required for flame retardance will be provided. The epoxy resin is better used in an amount of from 10 to 90 parts by weight, preferably from 20 to 50 parts by weight.

The curing agent is one or more selected from the group consisting of phenol curing agents, amine curing agents, acid or anhydride curing agent and cyanates.

The organic fire retardant is selected from the group consisting of melamine, melamine cyanurate (MCA), phosphate and compounds thereof, 9,10-dihydro-9-oxa-10-phosphaphenanthrene-10-oxide (DOPO) and compounds thereof, phenoxyl phosphonitrile, or mixtures thereof. As for such flame retardant, it is better not to reduce the dielectric constant, and it can be used alone or in combinations according to the synergistic flame retardant effect.

The curing accelerator is one or more selected from the group consisting of 2-methylimidazole, 1-methylimidazole, 2-ethyl-4-methylimidazole, 2-phenylimidazole, 2-hendecylimidazole, and 2-phenyl-4-methylimidazole.

The packing is one or more inorganic packings selected from the group consisting of aluminium hydroxide, magnesium hydroxide, zeolite, wollastonite, silicon dioxide, magnesia, calcium silicate, calcium carbonate, clay, talc and mica, wherein the optimal packing is silicon dioxide. The packing has a particle size median value of from 1 to 15 µm, preferably from 2 to 5 µm. The amount of the inorganic packing may be adjusted according to the application object, and is preferably from 10 to 90 wt.% relative to the total amount of the organic solids.

The initiator is a peroxide having the following structural formula 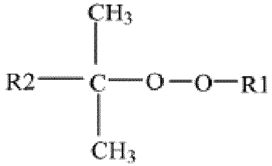 wherein R1 and R2 are H, alicyclic hydrocarbon with 3 to 20 carbon atoms and derivatives thereof, aliphatic hydrocarbon with 1 to 20 carbon atoms and derivatives thereof, or unsaturated aliphatic hydrocarbon with 2 to 20 carbon atoms and derivatives thereof. The initiator is better in an amount of form 0.1 to 10 parts by weight, preferably from 0.5 to 5 parts by weight.

The halogen-free low-dielectric resin composition has a phosphorus content of from 1 to 5 wt.%, a nitrogen content of from 1 to 5 wt.% and a halogen content of less than 0.09 wt.%.

The present invention further provides a prepreg fabricated by using the halogen-free low-dielectric resin composition, comprising a base material and a halogen-free low-dielectric resin composition attached thereon after impregnation and drying. The base material is a nonwoven fabric or other fabrics, *e.g*. natural fibers, organic synthetic fibers and inorganic fibers. The composition of the present invention is prepared by the conventional method, comprising firstly adding the solids, then adding the solvent which is one or more selected from the group consisting of acetone, butanone, cyclohexanone, ethylene glycol methyl ether, propylene glycol methyl ether, propylene glycol methyl ether acetate, stirring to complete dissolution, adding a liquid resin, continuously and homogeneously stirring. Said composition is added into a vessel; the accelerator, curing agent and initiator are firstly dissolved in a certain butanone solvent; the solid content of the solution is suitably adjusted with butanone solvent to 65-75% so produce a liquid cement; the liquid cement is impregnated with fabrics or organic fabrics such as glass fiber cloth; the impregnated glass fiber cloth is baked in an oven at 155 °C for 5-10 min to produce a prepreg.

The copper foil laminate made by using the halogen-free low-dielectric resin composition comprises several laminated prepregs, wherein each of the prepregs comprises a base material and a halogen-free low-dielectric resin composition attached thereon after impregnation and drying.

The printed circuit board of the present invention is made by coving copper foil (having a thickness of 35 µm) on one or two sides of the laminate made by bonding two or more prepregs via heating and compressing. Said copper foil lamination shall meet the following requirements: (1) the heating rate of the lamination shall generally be controlled within 1.0 to 3.0 °C/min at the feedstock temperature of 80-160 °C; (2) setting of lamination pressure: a full pressure of about 300 psi is applied when the outside feedstock is at a temperature of 80-100 °C; (3) while curing, the feedstock is controlled at a temperature of 200 °C and remains for 90 min. Besides copper foil, the metal foil for covering may also be nickel foil, aluminum foil, SUS foil and the like, and the material is not limited.

As for the aforesaid copper foil laminate (8 sheets of the bonding sheets) for use in the printed circuit board, the performances thereof, such as dielectric loss factor, heat resistance, hygroscopicity, glass transition temperature, flame retardance and the like, are measured, and further detailed explained and described in the following examples.

The present invention is detailedly explained by the following examples, but is not limited within the scope of the examples. If not specifically indicated, said part represents the part by weight, and said % represent wt.%.

### Epoxidized polybutadiene:

(A) Epoxidized polybutadiene (having an epoxy equivalent of 350 g/eq, from Sichuan EM Technology Co., Ltd.);

### Benzoxazine:

(B) Allyl benzoxazine (Sichuang University);

### Epoxy resin:

(C-1) o-methyl novolac epoxy resin (having an epoxy equivalent of 215 g/eq, DIC chemical product name);
(C-2) biscyclopentadiene-type epoxy resin (having an epoxy equivalent of 260 g/eq, DIC chemical product name);
(C-3) biphenyl-type epoxy resin NC-3000 (having an epoxy equivalent of 280 g/eq, produced by KYK).

### Curing agent:

(D-1) methyltetrahydrophthalic anhydride (produced by TCI Shanghai);
(D-2) styrene-maleic anhydride oligomer SMA-EF40 (US trade name sartomer).

### Organic fire retardant:

(E-1) melamine cyanurate (having an average particle size of 1 to 5 µm and a purity of higher than 95%);
(E-2) phenoxyl phosphonitrile (trade name from Otsuka Chemical Co., Ltd);
(E-3) phosphate flame retardant OP935 (chemical product name form Clariant);
(E-4) phosphorus-containing phenolic aldehyde (chemical product name from DOW).

### Curing accelerator:

(F) 2-methyl-4-ethylimidazole (Shikoku Chemicals Corporation).

### Initiator:

(G) 1,1,3,3-tetramethylbutyl hydrogen peroxide (from AkzoNobel)

### Packing:

(H) spherical quartz powder (having an average particle size of 3-5 µm, and a purity of higher than 99%).

**Table 1 Formulation (I) of the liquid cement composition (parts by weight)**

| | Example 1 | Example 2 | Example 3 | Com.Exp.1 | Com.Exp.2 |
|---|---|---|---|---|---|
| A | 15 | 22 | 35 | | 30 |
| B | 42 | 25 | 25 | 35 | |
| C-1 | | | | 30 | |
| C-2 | 12 | | 10 | | |
| C-3 | | 18 | | | 22 |
| D-1 | 18 | | | | |
| D-2 | | 25 | 22 | 25 | 35 |
| E-1 | 5 | | | | 5 |
| E-2 | 8 | | 8 | | 8 |
| E-3 | | 10 | | 10 | |
| E-4 | | | | | |
| F | right amount | right amount | right amount | right amount | right amount |
| G | 1.71 | 1.41 | 1.80 | 1.05 | 0.9 |
| H | 30 | 30 | 30 | 30 | 30 |

**Table 2 Formulation (II) of the liquid cement composition (parts by weight)**

| | Example 1 | Example 2 | Example 3 | Com.Exp.1 | Com.Exp.2 |
|---|---|---|---|---|---|
| A | 25 | 20 | 50 | 10 | 30 |
| B | 25 | 30 | 22 | 40 | 35 |
| C-1 | | 10 | | 10 | |
| C-2 | 10 | | | | |
| C-3 | | | | | |
| D-1 | | | 15 | 15 | |
| D-2 | 16 | 23 | | | 20 |
| E-1 | | | 5 | | |
| E-2 | | | 8 | | |
| E-3 | | 17 | | | 15 |
| E-4 | 24 | | | 25 | |
| F | right amount | right amount | right amount | right amount | right amount |
| G | 1.50 | 1.50 | 2.16 | 1.50 | 1.95 |
| H | 30 | 30 | 30 | 30 | 30 |

**Table 3 Property Evaluation Table (I)**

| | Example 1 | Example 2 | Example 3 | Com.Exp.1 | Com.Exp.2 |
|---|---|---|---|---|---|
| Glass transition temperature Tg (DSC, -C) | 175 | 172 | 165 | 161 | 155 |
| Peeling strength (N/mm) | 1.51 | 1.48 | 1.5 | 1.52 | 1.5 |
| Combustibility (UL94) | V-0 | V-0 | V-0 | V-0 | V-0 |
| Thermal stratification time T-288 (min) | >60 | >60 | >60 | >60 | 35 |
| Dip-soldering | ○ | ○ | ○ | ○ | ○ |
| resistance | | | | | |
| Dielectric constant (1GHz) | 3.5 | 3.8 | 3.6 | 4.1 | 4.0 |
| Dielectric loss (1GHz) | 0.002 | 0.005 | 0.003 | 0.01 | 0.008 |
| Hygroscopicity | 0.12 | 0.22 | 0.18 | 0.15 | 0.35 |
| Halogen content | 0.03 | 0.03 | 0.03 | 0.03 | 0.03 |
| Punching property | O | O | O | Δ | O |

**Table 4 Property Evaluation Table (II)**

| | Example 1 | Example 2 | Example 3 | Com.Exp.1 | Com.Exp.2 |
|---|---|---|---|---|---|
| Glass transition temperature Tg (DSC, °C) | 165 | 173 | 150 | 189 | 175 |
| Peeling strength (N/mm) | 1.49 | 1.52 | 1.35 | 1.5 | 1.48 |
| Combustibility (UL94) | V-0 | V-0 | V-1 | V-0 | V-0 |
| Thermal stratification time T-288 (min) | >60 | >60 | >45 | >60 | 35 |
| Dip-soldering resistance | ○ | ○ | ○ | ○ | ○ |
| Dielectric constant (1GHz) | 3.7 | 3.6 | 3.4 | 3.9 | 3.8 |
| Dielectric loss (1GHz) | 0.005 | 0.006 | 0.002 | 0.005 | 0.006 |
| Hygroscopicity | 0.13 | 0.11 | 0.33 | 0.14 | 0.2 |
| Halogen content | 0.03 | 0.03 | 0.03 | 0.03 | 0.03 |
| Punching property | ○ | ○ | ○ | Δ | ○ |

The aforesaid properties are measured by the following methods.
(1) Glass transition temperature (Tg): measured according to the differential scanning calorimetry (DSC) as stipulated under IPC-TM-650 2.4.25.
(2) Peeling strength: the peeling strength of the metal covering layer is measured according to the test conditions "after thermal stress" in the method of IPC-TM-650 2.4.8.
(3) Combustibility: measured according to UL 94 vertical firing method.
(4) Thermal stratification time T-288: measured according to the method of IPC-TM-650 2.4.24.1.
(5) The sample (the substrate material of 100x100 mm) which remains in pressure processing device at 121 °C and 105 Kpa for 2 hours is impregnated in a solder bath heated to 288 °C for 20 seconds to visually observe whether there is stratification. The symbol o in the tables represents unchanged; the symbol x represents stratification.
(6) Hygroscopicity: measured according to the method of IPC-TM-650 2.6.2.1.
(7) Dielectric Loss Tangent (1GHz): measured according to the resonance method using strip lines and IPC-TM-650 2.5.5.9.
(8) Punching property: the substrate material having a thickness of 1.60 mm is placed on a punch die having a certain figure for punching to visually observe (h1) no bright border at the hole edge; (h2) bright border at the hole edge; (h3) cleavage of the hole edge, which are respectively represented with O, Δ and x.
(9) Halogen content: measured according to method of IPC-TM-650 2.3.41.

In conclusion, it can be seen that the efficacies of low dielectric property, heat resistance, dip-soldering resistance, and hygroscopicity can be achieved according to the present invention. Meanwhile, the plate material has an excellent processability, and the halogen content can achieve the V-O standard in fire resistance test UL94 within the JPCA halogen-free standard scope. The present invention sufficiently utilizes the synergistic properties of epoxidized polybutadiene, benzoxazine, epoxy resin, initiator, and curing agent, and the halogen content is less than 0.09%, so as to achieve the efficacy of environmental protection. Additionally, the printed circuit board prepared by using the resin matrix of the present invention has the equivalent mechanical performance and heat resistance to the general FR-4 printed circuit board.

Those stated above are the preferred examples of the present invention. Those ordinarily skilled in the art can make various corresponding changes and deformations according to the technical solutions and concepts of the present invention, but all said changes and deformations shall belong to the protection scope of the present invention.

## Claims

1. A halogen-free low-dielectric resin composition, comprising, based on the weight of the organic solid,
from 5 to 90 parts by weight of epoxidized polybutadiene resin;
from 10 to 90 parts by weight of benzoxazine resin;
from 10 to 90 parts by weight of epoxy resin;
from 1 to 50 parts by weight of a curing agent;
from 10 to 50 parts by weight of an organic fire retardant;
from 0.01 to 1 parts by weight of a curing accelerator;
from 0.1 to 10 parts by weight of an initiator; and
from 10 to 100 parts by weight of a packing,
wherein the initiator is a peroxide having the following structural formula 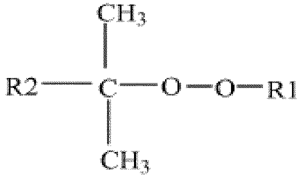 wherein R1 and R2 are H, alicyclic hydrocarbon with 3 to 20 carbon atoms and derivatives thereof, aliphatic hydrocarbon with 1 to 20 carbon atoms and derivatives thereof, or unsaturated aliphatic hydrocarbon with 2 to 20 carbon atoms and derivatives thereof.

2. The halogen-free low-dielectric resin composition according to claim 1, wherein said polybutadiene epoxy resin comprises at least one of the compounds having the following structural formula (I) 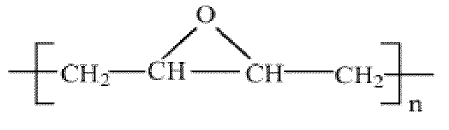 wherein the formula (I) represents cis-1,4-epoxidized polybutadiene, trans-1,4-epoxidized polybutadiene, cis-1,4-epoxidized hydroxyl terminated polybutadiene, trans-1,4-epoxidized hydroxyl terminated polybutadiene, cis-1,4-epoxidized carboxyl terminated polybutadiene, trans-1,4-epoxidized carboxyl terminated polybutadiene, having a molecular weight of from 100 to 10000;
and the formula (II) 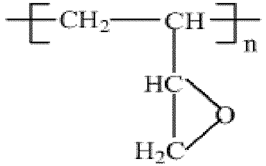 wherein the formula (2) represents 1,2-epoxidized polybutadiene, 1,2-epoxidized hydroxyl terminated polybutadiene, or 1,2-epoxidized carboxyl terminated polybutadiene, having a molecular weight of from 100 to 10000.

3. The halogen-free low-dielectric resin composition according to claim 1, wherein benzoxazine resin comprises one or more selected from the group consisting of allyl benzoxazine, bisphenol A-type benzoxazine, bisphenol F-type benzoxazine, 4,4'-diaminodiphenylmethane-type benzoxazine, biscyclopentadiene-type benzoxazine.

4. The halogen-free low-dielectric resin composition according to claim 1, wherein the epoxy resin comprises at least one of the following compounds
(1) bifunctional epoxy resin, including bisphenol A-type epoxy resin, bisphenol F-type epoxy resin, biphenyl-type epoxy resin, ;naphthalene ring-type epoxy resin, biscyclopentadiene-type epoxy resin and cyanate-type epoxy resin;
(2) novolac epoxy resin, including phenol novolac epoxy resin, bisphenol A-type novolac epoxy resin, and o-methyl novolac epoxy resin;
(3) phosphorous-containing epoxy resin, including 9,10-dihydro-9-oxa-10-phosphaphenanthrene-10-oxide-modified epoxy resin, 10-(2,5-dihydroxylnaphthyl)-9,10-dihydro-9-oxa-10-phosphaphenanthrene-10-oxide-modified epoxy resin, 10-(2,9-dihydroxylnaphthyl)-9,10-dihydro-9-oxa-10-phosphaphenanthrene-10-oxide-modified epoxy resin.

5. The halogen-free low-dielectric resin composition according to claim 1, wherein the curing agent is one or more selected from the group consisting of phenol curing agents, amine curing agents, acid or anhydride curing agent and cyanates;
the organic fire retardant is selected from the group consisting of melamine, melamine cyanurate, phosphate and compounds thereof, 9,10-dihydro-9- oxa-10-phosphaphenanthrene-10-oxide and compounds thereof, phenoxyl phosphonitrile, or mixtures thereof;
the curing accelerator is one or more selected from the group consisting of 2-methylimidazole, 1-methylimidazole, 2-ethyl-4-methylimidazole, 2-phenylimidazole, 2-hendecylimidazole, and 2-phenyl-4-methylimidazole; and
the packing is one or more inorganic packings selected from the group consisting of aluminium hydroxide, magnesium hydroxide, zeolite, wollastonite, silicon dioxide, magnesia, calcium silicate, calcium carbonate, clay, talc and mica.

6. The halogen-free low-dielectric resin composition according to claim 1, wherein the halogen-free low-dielectric resin composition has a halogen content of less than 0.09 wt.%.

7. A prepreg fabricated by using the halogen-free low-dielectric resin composition according to claim 1, comprising a base material and a halogen-free low-dielectric resin composition attached thereon after impregnation and drying.

8. The prepreg according to claim 7, wherein the base material is a nonwoven fabric or other fabrics.

9. A copper foil laminate made by using the halogen-free low-dielectric resin composition according to claim 1, comprising several laminated prepregs, copper foils covered on one or both sides of the laminated prepregs, wherein each of the prepregs comprises a base material and a halogen-free low-dielectric resin composition attached thereon after impregnation and drying.

## Patentansprüche

1. Halogenfreie niederdielektrische Harzzusammensetzung, enthaltend, bezogen auf das Gewicht des organischen Feststoffs,
5 bis 90 Gew.-Teile epoxidiertes Polybutadienharz;
10 bis 90 Gew.-Teile Benzoxazinharz;
10 bis 90 Gew.-Teile Epoxidharz;
1 bis 50 Gew.-Teile eines Härtungsmittels;
10 bis 50 Gew.-Teile eines organischen Flammschutzmittels;
0,01 bis 1 Gew.-Teile eines Härtungsbeschleunigers;
0,1 bis 10 Gew.-Teile eines Initiators; und
10 bis 100 Gew.-Teile eines Packmaterials,
wobei der Initiator ein Peroxid mit der folgenden Strukturformel ist 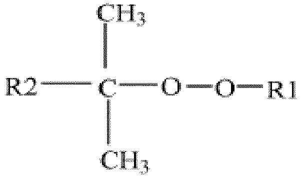 wobei R¹ und R² H, ein alicyclischer Kohlenwasserstoff mit 3 bis 20 Kohlenstoffatomen und Derivatendavon, ein aliphatischer Kohlenwasserstoff mit 1 bis 20 Kohlenstoffatomen und Derivate davon, oder ein ungesättigter aliphatischer Kohlenwasserstoff mit 2 bis 20 Kohlenstoffatomen und Derivate davon sind.

2. Halogenfreie niederdielektrische Harzzusammensetzung nach Anspruch 1, wobei das Polybutadien-Epoxidharz mindestens eine der Verbindungen der folgenden Strukturformel (I) 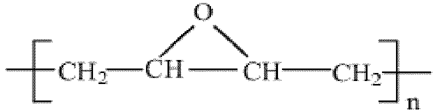 wobei die Formel (I) cis-1,4-epoxidiertes Polybutadien, trans-1,4-epoxidiertes Polybutadien, cis-1,4-epoxidiertes hydroxylterminiertes Polybutadien, trans-1,4-epoxidiertes hydroxylterminiertes Polybutadien, cis-1,4-epoxidiertes carboxylterminiertes Polybutadien, trans-1,4-epoxidiertes carboxylterminiertes Polybutadien mit einem Molekulargewicht von 100 bis 10000 darstellt;
und der Formel (II) 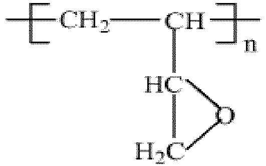 wobei die Formel (2) 1,2-epoxidiertes Polybutadien, 1,2-epoxidiertes hydroxylterminiertes Polybutadien oder 1,2-epoxidiertes carboxylterminiertes Polybutadien mit einem Molekulargewicht von 100 bis 10000 darstellt, umfasst.

3. Halogenfreie niederdielektrische Harzzusammensetzung nach Anspruch 1, wobei das Benzoxazinharz ein oder mehrere ausgewählt aus der Gruppe bestehend aus Allylbenzoxazin, Benzoxazin vom Bisphenol-A-Typ, Benzoxazin vom Bisphenol-F-Typ, Benzoxazin vom 4,4'-Diaminodiphenylmethan-Typ, Benzoxazin vom Biscyclopentadien-Typ enthält.

4. Halogenfreie niederdielektrische Harzzusammensetzung nach Anspruch 1, wobei das Epoxidharz mindestens eine der folgenden Verbindungen umfasst
(1) bifunktionelles Epoxidharz, einschließlich Epoxidharz vom Bisphenol-A-Typ, Epoxidharz vom Bisphenol-F-Typ, Epoxidharz vom Biphenyl-Typ, Epoxidharz vom Naphthalinring-Typ, Epoxidharz vom Dicyclopentadien-Typ und Epoxidharz vom Cyanat-Typ;
(2) Novolac-Epoxidharz, einschließlich Phenol-Novolac-Epoxidharz, Novolac-Epoxidharz vom Bisphenol-A-Typ, und o-Methyl-Novolac-Epoxidharz;
(3) phosphorhaltiges Epoxidharz, einschließlich 9,10-Dihydro-9-oxa-10-phosphaphenanthren-10-oxid-modifiziertes Epoxidharz, 10-(2,5-Dihydroxylnaphthyl)-9,10-dihydro-9-oxa-10-phosphaphenanthren-10-oxid-modifiziertes Epoxidharz, 10-(2,9-Dihydroxylnaphthyl)-9,10-dihydro-9-oxa-10-phosphaphenanthren-10-oxid-modifiziertes Epoxidharz.

5. Halogenfreie niederdielektrische Harzzusammensetzung nach Anspruch 1, wobei das Härtungsmittel eines oder mehrere ausgewählt aus der Gruppe, bestehend aus Phenol-Härtungsmitteln, Amin-Härtungsmitteln, Säure- oder Anhydrid-Härtungsmittel und Cyanaten, ist;
das organische Flammschutzmittel aus der Gruppe bestehend aus Melamin, Melamincyanurat, Phosphat und Verbindungen davon, 9,10-Dihydro-9-oxa-10-phosphaphenanthren-10-oxid und Verbindungen davon, Phenoxylphosphonitril, oder Mischungen davon ausgewählt ist;
der Härtungsbeschleuniger einer oder mehrere ausgewählt aus der Gruppe bestehend aus 2-Methylimidazol, 1-Methylimidazol, 2-Ethyl-4-methylimidazol, 2-Phenylimidazol, 2-Hendecylimidazol und 2-Phenyl-4-methylimidazol ist; und
wobei das Packmaterial ein oder mehrere anorganische Packmaterialien, ausgewählt aus der Gruppe bestehend aus Aluminiumhydroxid, Magnesiumhydroxid, Zeolith, Wollastonit, Siliciumdioxid, Magnesiumoxid, Calciumsilicat, Calciumcarbonat, Ton, Talk und Glimmer, ist.

6. Halogenfreie niederdielektrische Harzzusammensetzung nach Anspruch 1, wobei die halogenfreie niederdielektrische Harzzusammensetzung einen Halogengehalt von weniger als 0,09 Gew.-% aufweist.

7. Prepreg, hergestellt unter Verwendung der halogenfreien niederdielektrischen Harzzusammensetzung nach Anspruch 1, umfassend ein Grundmaterial und eine nach dem Imprägnieren und Trocknen daran gebundene halogenfreie niederdielektrische Harzzusammensetzung.

8. Prepreg nach Anspruch 7, wobei das Grundmaterial ein Vliesstoff oder ein anderes Gewebe ist.

9. Kupferfolienlaminat, hergestellt unter Verwendung der halogenfreien niederdielektrischen Harzzusammensetzung nach Anspruch 1, umfassend mehrere laminierte Prepregs und Kupferfolien, die eine oder beide Seiten der laminierten Prepregs bedecken, wobei jedes der Prepregs ein Grundmaterial und eine nach dem Imprägnieren und Trocknen daran gebundene halogenfreie niederdielektrische Harzzusammensetzung umfasst.

## Revendications

1. Composition de résine exempte d'halogène et à faible constante
diélectrique, comprenant, sur la base du poids du solide organique,
de 5 à 90 parties en poids d'une résine de polybutadiène époxydé ;
de 10 à 90 parties en poids d'une résine de benzoxazine ;
de 10 à 90 parties en poids d'une résine époxy ;
de 1 à 50 parties en poids d'un agent de durcissement ;
de 10 à 50 parties en poids d'un ignifuge organique ;
de 0,01 à 1 partie en poids d'un accélérateur de durcissement ; de 0,1 à 10 parties en poids d'un initiateur ; et
de 10 à 100 parties en poids d'un garnissage,
dans laquelle l'initiateur est un peroxyde ayant la formule structurelle suivante 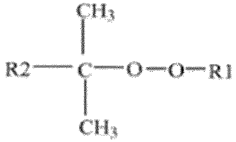 dans laquelle R1 et R2 sont H, un hydrocarbure alicyclique contenant 3 à 20 atomes de carbone et ses dérivés, un hydrocarbure aliphatique contenant 1 à 20 atomes de carbone et ses dérivés, ou un hydrocarbure aliphatique insaturé contenant 2 à 20 atomes de carbone et ses dérivés.

2. Composition de résine exempte d'halogène et à faible constante diélectrique selon la revendication 1, dans laquelle ladite résine de polybutadiène époxydé comprend au moins un des composés ayant la forme structurelle (I) suivante 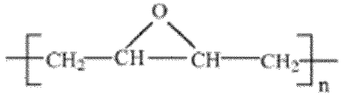 dans laquelle la formule (I) représente un polybutadiène cis-1,4-époxydé, un polybutadiène trans-1,4-époxydé, un polybutadiène à terminaison hydroxyle cis-1,4-époxydé, un polybutadiène à terminaison hydroxyle trans-1,4-époxydé, un polybutadiène à terminaison carboxyle cis-1,4-époxydé, un polybutadiène à terminaison carboxyle trans-1,4-époxydé, possédant une masse moléculaire de 100 à 10 000 ;
et la formule (II) 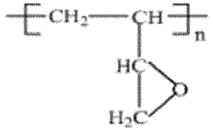 dans laquelle la formule (2) représente un polybutadiène 1,2-époxydé, un polybutadiène 1,2-époxydé à terminaison hydroxyle, ou un polybutadiène 1,2-époxydé à terminaison carboxyle, possédant une masse moléculaire de 100 à 10 000.

3. Composition de résine exempte d'halogène et à faible constante diélectrique selon la revendication 1, dans laquelle la résine de benzoxazine comprend une ou plusieurs sélectionnées dans le groupe consistant en l'allylbenzoxazine, une benzoxazine de type bisphénol A, une benzoxazine de type bisphénol F, une benzoxazine de type 4,4'-diaminodiphénylméthane, une benzoxazine de type biscyclopentadiène.

4. Composition de résine exempte d'halogène et à faible constante diélectrique selon la revendication 1, dans laquelle la résine époxy comprend au moins un des composés suivants
(1) une résine époxy bifonctionnelle, comprenant une résine époxy de type bisphénol A, une résine époxy de type bisphénol F, une résine époxy de type biphényle, une résine époxy de type cycle naphtalène, une résine époxy de type biscyclopentadiène et une résine époxy de type cyanate ;
(2) une résine époxy novolaque, comprenant une résine époxy novolaque de phénol, une résine époxy novolaque de type bisphénol A, et une résine époxy novolaque o-méthylée ;
(3) une résine époxy phosphorée, comprenant une résine époxy modifiée par le 9,10-dihydro-9-oxa-10-phosphaphénanthrène-10-oxyde, une résine époxy modifiée par le 10-(2,5-dihydroxylnaphtyl)-9,10-dihydro-9-oxa-10-phosphaphénanthrène-10-oxyde, une résine époxy modifiée par le 10-(2,9-dihydroxylnaphtyl)-9,10-dihydro-9-oxa-10-phosphaphénanthrène-10-oxyde.

5. Composition de résine exempte d'halogène et à faible constante diélectrique selon la revendication 1, dans laquelle l'agent de durcissement est un ou plusieurs sélectionnés dans le groupe consistant en les agents de durcissement de type phénol, les agents de durcissement de type amine, les agents de durcissement de type acide ou anhydride et les cyanates ;
l'ignifuge organique est sélectionné dans le groupe consistant en la mélamine, le cyanurate de mélamine, un phosphate et les composés de celui-ci, le 9,10-dihydro-9-oxa-10-phosphaphénanthrène-10-oxyde et les composés de celui-ci, le phénoxyl-phosphonitrile, ou leurs mélanges ;
l'accélérateur de durcissement est un ou plusieurs sélectionnés dans le groupe consistant en le 2-méthylimidazole, le 1-méthylimidazole, le 2-éthyl-4-méthylimidazole, le 2-phénylimidazole, le 2-hendécylimidazole, et le 2-phényl-4-méthylimidazole ; et
le garnissage est un ou plusieurs garnissages inorganiques sélectionnés dans le groupe consistant en l'hydroxyde d'aluminium, l'hydroxyde de magnésium, une zéolithe, la wollastonite, le dioxyde de silicium, l'oxyde de magnésium, le silicate de calcium, le carbonate de calcium, l'argile, le talc et le mica.

6. Composition de résine exempte d'halogène et à faible constante diélectrique selon la revendication 1, dans laquelle la composition de résine exempte d'halogène et à faible constante diélectrique présente une teneur en halogène inférieure à 0,09 % en poids.

7. Préimprégné fabriqué en utilisant la composition de résine exempte d'halogène et à faible constante diélectrique selon la revendication 1, comprenant un matériau de base et une composition de résine exempte d'halogène et à faible constante diélectrique fixée dessus après imprégnation et séchage.

8. Préimprégné selon la revendication 7, dans lequel le matériau de base est un tissu non tissé ou d'autres tissus.

9. Stratifié de feuille de cuivre préparé en utilisant la composition de résine exempte d'halogène et à faible constante diélectrique selon la revendication 1, comprenant plusieurs préimprégnés stratifiés, des feuilles de cuivre recouvrant une ou les deux faces des préimprégnés stratifiés, dans lequel chacun des préimprégnés comprend un matériau de base et une composition de résine exempte d'halogène et à faible constante diélectrique fixée dessus après imprégnation et séchage.
